# EUROPÄISCHE PATENTSCHRIFT

(11) **EP 1 239 525 B1**
(45) Veröffentlichungstag und Bekanntmachung des Hinweises auf die Patenterteilung: **12.09.2007**
(21) Anmeldenummer: 02003957.4
(22) Anmeldetag: 22.02.2002
(51) Int. Cl.: H01L 41/083, H01L 41/24

(54) **Piezokeramische Vielschichtaktoren sowie ein Verfahren zu ihrer Herstellung**
Piezoceramic multilayer actuators and method of manufacturing
Actionneurs à multicouches piézocéramiques et méthode de fabrication

(30) Priorität: 06.03.2001 DE 10110617; 13.02.2002 DE 10206115
(43) Veröffentlichungstag der Anmeldung: 11.09.2002
(73) Patentinhaber: Ceram Tec Ag Innovative Ceramic Engineering, 73207 Plochingen (DE)
(72) Erfinder: Bindig, Reiner, 95463 Bindlach (DE); Schreiner, Hans-Jürgen, Dr., 91233 Neunkirchen am Sand-Rollhofen (DE)
(74) Vertreter: Uppena, Franz

(56) Entgegenhaltungen:
- EP-A- 0 479 328
- EP-A- 0 516 188
- DE-A1- 19 648 545
- DE-A1- 19 753 930

## Beschreibung

Die Erfindung betrifft piezokeramische Vielschichtaktoren sowie ein Verfahren zu ihrer Herstellung.

Piezokeramische Vielschichtaktoren werden als Monolithen hergestellt, das heißt, der aktive Werkstoff, auf dem vor dem Sintern durch ein Siebdruckverfahren Innenelektroden aufgetragen werden, wird als sogenannte Grünfolie zu einem Stapel aufeinandergelegt, der zu einem Grünkörper verpresst wird. Das Verpressen des Grünkörpers wird in der Regel durch Laminieren unter Druck- und Temperatureinwirkung in Laminierformen durchgeführt.

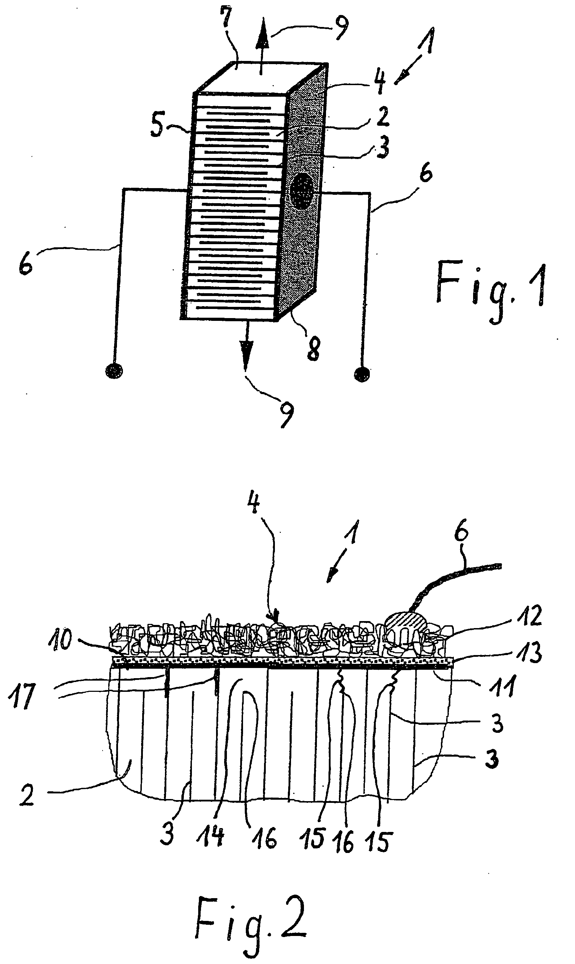

In Figur 1 ist ein solcherart hergestellter piezokeramischer Vielschichtaktor 1 stark vergrößert schematisch dargestellt. Der Aktor besteht aus gestapelten dünnen Schichten 2 piezoelektrisch aktiven Werkstoffs, beispielsweise Blei-Zirkonat-Titanat (PZT), mit dazwischen angeordneten leitfähigen Innenelektroden 3, die alternierend an die Aktoroberfläche geführt werden. Außenelektroden 4, 5 verbinden die Innenelektroden 3. Dadurch werden die Innenelektroden 3 elektrisch parallel geschaltet und zu zwei Gruppen zusammengefasst. Die beiden Außenelektroden 4, 5 sind die Anschlusspole des Aktors 1. Sie sind über die Anschlüsse 6 mit einer hier nicht dargestellten Spannungsquelle verbunden. Wird über die Anschlüsse 6 eine elektrische Spannung an die Außenelektroden 4, 5 gelegt, wird diese auf alle Innenelektroden 3 parallel übertragen und verursacht ein elektrisches Feld in allen Schichten 2 des aktiven Werkstoffs, der sich dadurch mechanisch verformt. Die Summe aller dieser mechanischen Verformungen steht an der Endfläche des Kopfbereichs 7 sowie an der Endfläche des Fußbereichs 8 des Vielschichtaktors 1 als nutzbare Dehnung und/oder Kraft 9 zur Verfügung.

Die Figur 2 zeigt einen Schnitt durch die Außenelektrode 4 und die Oberfläche des piezokeramischen Vielschichtaktors 1 nach dem Stand der Technik. In dieser Figur ist der Aufbau einer Außenelektrode zu sehen. Auf die zu einem Stapel gepressten dünnen Schichten 2 des piezoelektrisch aktiven Materials wird im Bereich der an die Oberfläche 10 des Vielschichtaktors 1 herausgeführten Innenelektroden 3, beispielsweise durch galvanische Verfahren oder Siebdruck von Metallpaste, eine Grundmetallisierung 11 zur Verbindung der gleichgepolten Innenelektroden 3 aufgebracht. Diese Grundmetallisierung 11 wird durch eine weitere Schicht 12 aus einem metallischen Werkstoff verstärkt, beispielsweise durch ein strukturiertes Blech oder ein Drahtnetz. Die Verbindung der Verstärkungsschicht 12 mit der Grundmetallisierung 11 erfolgt mittels einer Verbindungsschicht 13, in der Regel einer Lotschicht. An die Verstärkungsschicht 12 wird der elektrische Anschlussdraht 6 gelötet.

Außenelektroden auf der Oberfläche 10 eines Aktors 1, die wie beschrieben aufgebaut sind, weisen einen gravierenden Nachteil auf. Während des Betriebes wirken auf den inaktiven Bereich, den Isolierbereich 14, der unter der Grundmetallisierung 11 liegt, starke Zugspannungen. Da dieser Isolierbereich 14 zusammen mit der Grundmetallisierung 11 und der Verbindungsschicht 13 eine homogene Einheit bildet, versagt diese beim Überschreiten der Zugfestigkeit des schwächsten Gliedes und es bilden sich Risse. Der dargestellte Rissverlauf tritt nach etwa 10⁶ Belastungszyklen auf. Aufgrund der auftretenden Spannungen verlaufen die Risse 15 in der Regel von der spröden und wenig zugfesten Grundmetallisierung 11 in den Isolierbereich 14 und werden dort von Bereichen mit hohen Zugspannungen eingefangen, bevorzugt an den Elektrodenspitzen 16 der nicht die Grundmetallisierung 11 berührenden Elektroden 3, oder sie beginnen in den Bereichen maximaler Zugspannung an den Elektrodenspitzen 16 und verlaufen in Richtung der Grundmetallisierung 11. Die Ausbreitung eines Risses 17 entlang einer die Grundmetallisierung 11 berührenden Innenelektrode 3 ist als unkritisch einzustufen, da ein solcher Rissverlauf die Funktion des Aktors nicht beeinträchtigt. Risse 15 dagegen, die unkontrolliert durch den Isolierbereich 14 verlaufen, sind sehr kritisch, da sie den Isolationsabstand verringern und die Wahrscheinlichkeit eines Aktorausfalls durch Überschläge stark erhöhen.

Problemlösungen werden zum Beispiel in den Patentanmeldungen DE 198 60 001 A1, DE 394 06 19 A1, DE 196 05 214 A1 beschrieben. Es wird dort vorgeschlagen, den Bereich zwischen einer nicht die Grundmetallisierung berührenden Elektrode und der Grundmetallisierung mit einem Füllmaterial geringer Zugfestigkeit oder einem Hohlraum zu versehen. Die wesentlichen Nachteile dieser Vorgehensweise sind darin zu sehen, dass das Füllmaterial mit einem zusätzlichen, komplexen Verfahrensschritt aufgebracht werden muss, dass das Füllmaterial unvermeidbar die Eigenschaften der Aktors negativ beeinflusst und im Falle der eingebrachten Hohlräume diese in einem weiteren Verfahrensschritt vor dem Aufbringen der Grundmetallisierung wieder geschlossen werden müssen.

Eine andere Problemlösung wird in DE 199 28 178 A1 vorgeschlagen. Hier wird der monolithische Aufbau in kleine Teilbereiche zerlegt und alternierend mit inaktiven, elektrodenfreien Bereichen wieder aufgebaut. Hierbei soll innerhalb eines aktiven Bereiches die maximal mögliche Zugspannung unterhalb des zur Rissbildung notwendigen Wertes bleiben. Das Verfahren ist fertigungstechnisch schwierig und führt nicht zur notwendigen Reduktion der Spannungen im Isolierbereich, so dass immer eine latente Rissgefahr bestehen bleibt.

Aus der EP 0 479 328 A2 ist ein piezokeramischer Vielschichtaktor bekannt, in dessen Oberfläche parallel zu den Innenelektroden Schlitze verlaufen. Die Schlitze werden dadurch erzeugt, dass zunächst Werkstoffe die Räume der Schlitze im Grünkörper einnehmen, welche dann durch thermische Zersetzung aus dem Körper entfernt werden.

In der DE 196 48 545 A1 wird beschrieben, wie durch dreidimensional strukturierte, elektrisch leitende Elektroden die in der Grundmetallisierung auftretenden Risse überbrückt werden.

Aus der EP 0 516 188 A1 sind Düsenköpfe für Tintenstrahldrucker bekannt, deren Düsen mit piezokeramischen Vielschichtaktoren betätigt werden. Es wird die Herstellung der Düsenköpfe beschrieben, wobei durch Zersägen monolithischer Aktoren die Aufteilung auf die einzelnen Düsen erfolgt.

Aufgabe der Erfindung ist es, die Vielschichtaktoren so zu gestalten, dass die in den Vielschichtaktoren zur Rissbildung führenden Ursachen möglichst vermieden werden.

Die Lösung der Aufgabe erfolgt dadurch, dass auf der Oberfläche des inaktiven Bereichs, des Isolierbereichs, durch die Oberfläche unterbrechende Abtragungen eine Struktur erzeugt wird. Die Grundmetallisierung wird ausschließlich auf der durch die Struktur verbliebene Oberfläche aufgetragen. Dadurch ist die Außenelektrode nicht vollflächig mit der Oberfläche des Vielschichtaktors verbunden und die Steifigkeit des Verbundes, bestehend aus der Oberfläche des Isolierbereichs, der Grundmetallisierung, der Verbindungsschicht und der Verstärkungsschicht wird herabgesetzt. Die Strukturierung bewirkt, dass die mechanische Rückwirkung der Außenelektrode auf den Aktor verringert wird. Die im Isolierbereich auftretenden Zugspannungen können sich nicht mehr zu einer kritischen Größe aufaddieren, die die Festigkeit des keramischen Werkstoffs übersteigt und sich in Rissen entlädt.

Eine optimale Wirkung wird erzielt, wenn die Tiefe der die Struktur erzeugenden Abtragungen an der Oberfläche des Aktors der Dicke des Isolierbereichs entspricht. Der Werkstoff des Isolierbereichs wird ständig unterbrochen, so dass auftretende Spannungen nicht weitergeleitet werden können und sich dadurch auch nicht zu einer kritischen Größe aufaddieren können. Die Dicke des Isolierbereichs ist unter anderem auch von der Größe des Aktors abhängig. Bei vollständiger Ausnutzung der Dicke des Isolierbereichs kann die Tiefe der Struktur, die Tiefe der Abtragungen, etwa bis zu 0,5 mm betragen.

Die Struktur kann an einem Aktor sowohl im Grünzustand als auch im gesinterten Zustand erfolgen. Die Bearbeitung im Grünzustand ist die vorteilhaftere, weil sie aufgrund des noch weicheren keramischen Werkstoffs werkzeugschonender ist und auch mit anderen Verfahren als dem üblichen Schleifverfahren durchgeführt werden kann. Ein weiterer Vorteil besteht darin, dass die beim Sintern entstehende Sinterhaut die in den Grünkörper eingebrachte Struktur bedeckt und isoliert. Dadurch ist sie zuverlässig gegen elektrische Überschläge und Feuchtigkeit geschützt.

Das Unterbrechen der Oberfläche des Isolierbereichs durch Abtragungen, insbesondere im Grünzustand, lässt sich auf einfache Weise durch jedes spangebende Bearbeitungsverfahren bewerkstelligen. Im gesinterten Zustand eines Aktors bietet sich neben dem Schleifen noch die Bearbeitung mit einem geeigneten Laser an. Die nach dem Sintern durch das Schleifen bearbeitete Oberfläche muss allerdings nachträglich isoliert werden, beispielsweise mit einem Polymerwerkstoff.

Die einfachste Abtragung der Oberfläche ist das Einbringen von linienförmigen Strukturen, insbesondere Nuten in Form von Rillen oder Kerben, weil sie sich auch für eine gezielte Strukturierung größerer Flächen eignen. Dabei können die Nuten parallel verlaufen.

Die Breite einer Nut, der Abstand zwischen zwei Nuten und der Winkel dieser Nuten gegenüber der Längsachse des Aktors müssen so aufeinander abgestimmt werden, dass nicht mehr als eine bestimmte Anzahl von Innenelektroden zwischen zwei Nuten an die Aktoroberfläche tritt. Diese maximale Anzahl ist abhängig von der spezifischen Dehnung des Aktors im Betrieb und der Festigkeit des keramischen Werkstoffs. Die Nuten können in einem Abstand von 0,2 mm bis 10 mm angeordnet sein, auf die Größe des Aktors abgestimmt. Als besonders geeignet hat sich zwischen zwei Nuten ein Abstand von etwa fünf Lagen von Innenelektroden oder ein Abstand von etwa 0,8 mm bis 1,2 mm erwiesen. Wird die Anzahl der Innenelektroden zu hoch gewählt, so addieren sich die Zugspannungen von Elektrode zu Elektrode auf und überschreiten den kritischen Wert, der zur Rissbildung führt.

Die Nuten sind in einem Winkel von 0 Grad bis 80 Grad zur Längsachse des Aktors angeordnet. Bei 0 Grad verlaufen die Nuten parallel zur Längsachse des Aktors. Vorteilhaft ist ein Bereich von 50 Grad bis 30 Grad. Wird als Schnittwinkel beispielsweise 45° gewählt, so ergeben sich als günstige Parameter ein Abstand zwischen zwei Nuten und eine Breite der Nuten von etwa 0,7 mm, etwa 1mm/√2.

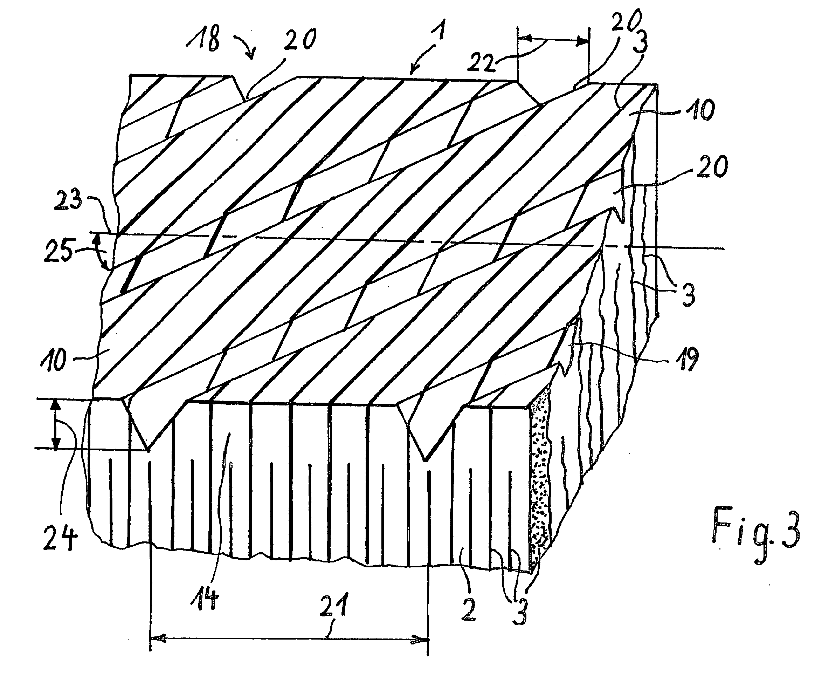

Beispielhaft wird anhand der Figuren 3, 4 und 5 die Herstellung eines erfindungsgemäßen Vielschichtaktors beschrieben. Ein niedrig sinternder piezokeramischer Werkstoff, beispielsweise der aus der DE 198 40 488 A1 bekannte SKN53, wird mit einem organischen Bindemittel als 125 µm dicke Grünfolie präpariert. Auf diese Grünfolie wird eine Innenelektrodenpaste aus Silber-Palladium-Pulver mit einem Gewichtsverhältnis der Anteile von 70/30 und einem geeigneten Bindemittel mittels Siebdruck aufgebracht. Eine Vielzahl derartiger Grünfolien wird zu einem Block aufeinandergestapelt und unter den bekannten Bedingungen von Druck und Temperatur laminiert. Aus dem Laminat werden die einzelnen stabförmigen Aktoren herausgetrennt.

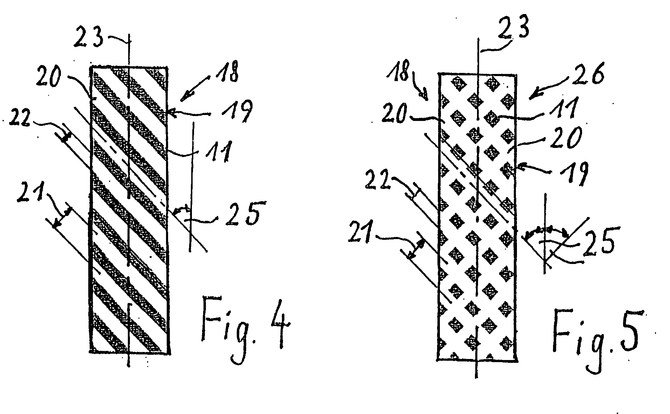

Erfindungsgemäß werden dann, wie in Figur 3 in einem perspektivisch gezeichneten Ausschnitt zu sehen ist, in die Oberfläche 10 eines jeden einzelnen Vielschichtaktors 1 in einem spangebenden Bearbeitungsverfahren, beispielsweise mit einem Scheibenfräser, auf den zu kontaktierenden Seiten unter einem geeignetem Winkel 25 zur Längsachse 23 des Aktors 1 Nuten 20 mit einer solchen Tiefe 24 eingefräst, dass der inaktive Isolierbereich 14 völlig durchtrennt wird. Das Einfräsen der Nuten 20 wird in regelmäßigen Abständen 21 wiederholt. Die dadurch entstehenden Unterbrechungen 19 in der Oberfläche 10 des Aktors bilden eine Strukturierung 18 in Form paralleler Streifen, wie in Figur 4 dargestellt.

Die Breite 22 einer Nut 20, der Abstand 21 zwischen zwei Nuten 20 und der Winkel 25 der Nuten 20 zur Längsachse 25 sind hier so aufeinander abgestimmt, dass nicht mehr als fünf Innenelektroden 3 zwischen zwei Nuten 20 an die Oberfläche 10 des Aktors treten. Figur 3 zeigt die nicht metallisierte Oberfläche 10 des Aktors, auf der sich der Verlauf der an die Oberfläche 10 tretenden Innenelektroden 3 sowie der Verlauf der Nuten 20 verfolgen lässt.

Auf der durch die Strukturierung 18 verbliebenen Oberfläche 10 des Aktors 1 wird, wie in Figur 4 ersichtlich, mittels eines Druckverfahrens die Grundmetallisierung 11 aus einer silberhaltigen Einbrennpaste aufgebracht. Nach dem Einbrennen der Grundmetallisierung 11 werden die Außenelektroden durch ein aufgelötetes Metalldraht-Netz vervollständigt.

In Figur 5 ist die Oberfläche 10 eines Aktors 1 dargestellt, der nach dem oben beschriebenen Verfahren präpariert worden ist. Seine Strukturierung 18 besteht aus sich kreuzenden Nuten 20. Diese schneiden jeweils die Längsachse 23 des Aktors unter einem Winkel 25 und bilden dadurch eine Gitterstruktur 26. Auch hier ist zunächst nur die Grundmetallisierung 11 auf die Oberfläche 10 des Aktors aufgebracht, die durch die Abtragungen, die Nuten 20, verblieben ist.

Die dergestalt im Grünzustand vorbereiteten Aktoren werden bei etwa 400°C pyrolysiert und bei etwa 1100 °C gesintert.

Anhand der nachfolgenden Ausführungsbeispiele wird nachgewiesen, dass durch die Erfindung die Ursache der Rissbildung in Vielschichtaktoren beseitigt wird.

Entsprechend dem oben beschriebenen Verfahren wurden als erste Variante ein Aktorgrundkörper mit einer Querschnittsfläche von 12,50 mm x 12,50 mm und 37,50 mm Länge als Grünkörper hergestellt. Die Dicke einer Keramikeinzellage, einer Grünfolie, betrug 125 µm, die Dicke der Metallisierungsschicht der Innenelektrode 3 µm. Diese Ausführungsvariante diente als Referenzmuster und stellte den Stand der Technik dar.

Entsprechend dem oben beschriebenen Verfahren wurden als zweite Variante ein Aktorgrundkörper mit einer Querschnittsfläche von 12,50 mm x 12,50 mm und 37,50 mm Länge als Grünkörper hergestellt. Die Dicke einer Keramikeinzellage, einer Grünfolie, betrug 125 µm, die Dicke der Metallisierungsschicht der Innenelektrode 3 µm. Die Aktorgrundkörper wurden auf den mit einer Außenelektrode zu kontaktierenden Seiten mit einem Scheibenfräser mit 0,7 mm Schnittbreite unter einem Winkel von 45° zur Aktorlängsachse in regelmäßigen Abständen eingefräst. Die Tiefe der Nuten von 0,5 mm entsprach der Dicke des Isolierbereichs. Der Abstand zwischen den Nuten betrug jeweils 0,7 mm.

Entsprechend dem oben beschriebenen Verfahren wurden als dritte Variante, welche nicht Bestandteil der Erfindung ist, ein Aktorgrundkörper mit einer Querschnittsfläche von 12,50 mm x 12,50 mm und 37,50 mm Länge als Grünkörper hergestellt. Die Dicke einer Keramikeinzellage, einer Grünfolie, betrug 125 µm, die Dicke der Metallisierungsschicht der Innenelektrode 3 µm. Die Aktorgrundkörper wurden auf den zu kontaktierenden Seiten mit einem Scheibenfräser mit 0,2 mm Schnittbreite unter einem Winkel von 90° zur Aktorlängsachse in regelmäßigen Abständen eingefräst. Die Tiefe der Nuten von 0,5 mm entsprach der Dicke des Isolierbereichs. Der Abstand zwischen den Nuten betrug jeweils 1,0 mm. Der Verlauf der Nuten in diesem Test entspricht nicht dem in der Praxis vorgesehenen Verlauf, weil durch ihn eine von der Nutenbreite abhängige Anzahl von Innenelektroden, die an die Oberfläche geführt sind, weggefräst und nicht an die Außenelektrode angeschlossen wurde. Der Nutenverlauf wurde gewählt, weil die Nuten wie Kerben wirken und damit bei der Längsausdehnung eines Aktors die ungünstigste Wirkung auf seine Zugfestigkeit haben. Es sollte geprüft werden, welche Auswirkungen eventuell zusätzlich auftretende Risse auf die Struktur der Oberfläche haben könnten.

Entsprechend dem oben beschriebenen Verfahren wurde als vierte Variante ein Körper mit einer Querschnittsfläche von 100 mm x 12,50 mm und 37,50 mm Länge als Grünkörper hergestellt, der nach dem Erzeugen der Struktur in acht einzelne stabförmige Aktorgrundkörper zerlegt wurde. Die Dicke einer Keramikeinzellage, einer Grünfolie, betrug 125 µm, die Dicke der Metallisierungsschicht der Innenelektrode 3 µm. Die Aktor-Riegel wurden auf den zu kontaktierenden Seiten mit einem Scheibenfräser mit 0,7 mm Schnittbreite unter einem Winkel von 45° zur Aktorlängsachse in regelmäßigen Abständen eingefräst. Die Tiefe der Nuten von 0,5 mm entsprach der Dicke des Isolierbereichs. Der Abstand zwischen den Nuten betrug jeweils 0,7 mm.

Die Aktorgrundkörper der obigen vier Ausführungsbeispiele wobei das dritte nicht Gegenstand der Erfindung ist, wurden bei etwa 400°C pyrolysiert und anschließend bei etwa 1100 °C gesintert.

Entsprechend dem oben beschriebenen Verfahren wurden als fünfte Variante Aktorgrundkörper mit einer Querschnittsfläche von 12,50 mm x 12,50 mm und 37,50 mm Länge als Grünkörper hergestellt. Die Dicke einer Keramikeinzellage, einer Grünfolie, betrug 125 µm, die Dicke der Metallisierungsschicht der Innenelektrode 3 µm. Die Aktorgrundkörper wurden pyrolysiert und gesintert. Erst danach wurden mit einer Diamantsäge auf den zu kontaktierenden Seiten Schnitte mit 0,2 mm Schnittbreite unter einem Winkel von 45° zur Aktorlängsachse in regelmäßigen Abständen eingefräst. Die Tiefe der Nuten von 0,4 mm entsprach der Dicke des Isolierbereichs. Der Abstand zwischen den Nuten betrug 0,6 mm. Nach sorgfältiger Reinigung wurden die Nuten mit einem Silikonharz gefüllt. Das Harz wurde bei 140°C ausgehärtet.

Bei den Vielschichtaktoren der obigen fünf Varianten wurden die Kontaktseiten zum Anschluss der Außenelektroden und die Stirnflächen der Kopf- und Fußbereiche durch Schleifen bearbeitet. Auf den restlichen Seiten verblieb die Sinterhaut als Isolierschicht.

Auf die Aktorkörper der fünf Varianten wurden nach dem Sintern mit einem bekannten Verfahren die Außenelektroden, die aus einem Drahtnetz bestanden, aufgelötet. Der Werkstoff des Netzes war ein dem thermischen Ausdehnungskoeffizienten des Keramikwerkstoffs angepasster Werkstoff, beispielsweise FeNi₃₆. Der Drahtdurchmesser betrug 100 µm, die Maschenweite 200 µm. Das Netz war galvanisch vorbehandelt, beispielsweise verkupfert, um die Lötbarkeit zu ermöglichen. Als Lot wurde SnAg₄ verwendet. Die Lötzeit betrug 2 Minuten bei 240 °C.

Die so hergestellten Vielschichtaktoren wurden gereinigt und mit einer geeigneten Lackierung isoliert. Nach dem Anlöten von Anschlussdrähten an die Elektrodennetze wurden die Aktoren in Prüfrahmen mit 2000 N vorgespannt und mit einem Trapezsignal angesteuert. Dabei wurde die Ansteuerspannung in 100 µs von 0 V auf 200 V angehoben, 1 ms auf 200 V gehalten, und dann in 100 µs auf 0 V erniedrigt. Die Wiederholfrequenz war 200 Hz. Die Aktoren erreichten dabei Betriebstemperaturen von 150 bis 160 °C.

Die erste Variante als Stand der Technik zeigte bereits bei 10⁶ Zyklen deutliche und starke Rissbildung. Die Risse durchtrennen die Isolierzone in beliebigen Richtungen, Risse entlang der Innenelektroden traten weniger auf.

Die Varianten zwei bis fünf zeigten nahezu identisches Verhalten, das sich von dem der ersten Variante deutlich unterschied. Auch nach 10⁸ Zyklen traten in den Aktoren keine Risse auf.

## Patentansprüche

1. Piezokeramischer Vielschichtaktor (1) mit alternierend an sich gegenüberliegenden Oberflächen (10) des Aktors (1) geführten Innenelektroden (3), die auf der jeweiligen Oberfläche (10) durch eine Außenelektrode (4, 5) miteinander verbunden sind, wobei die Oberfläche (10) des Vielschichtaktors (1) im inaktiven Bereich (14) eine Struktur (18) aufweist, die durch die Oberfläche (10) unterbrechende Abtragungen (19) erzeugt ist, deren Tiefe (24) der Dicke des Isolierbereichs (14) entspricht, **dadurch gekennzeichnet, dass** die Außenelektrode (4, 5) aus mindestens einer auf dem inaktiven Bereich (14) des Aktors (1) aufgetragenen Schicht einer Grundmetallisierung (11) besteht, mit der mittels einer Verbindungsschicht (13) eine Verstärkungsschicht (12) verbunden ist, an der ein Anschluss (6) zu einer Spannungsquelle angelötet sein kann, dass die Grundmetallisierung (11) ausschließlich auf der durch die Struktur (18) verbliebenen Oberfläche (10) aufgetragen ist und dass die die Struktur (18) erzeugenden Abtragungen (19) in einem Winkel von 0 Grad bis 80 Grad, vorzugsweise von 30 Grad bis 50 Grad, zur Längsachse (23) des Aktors (1) verlaufen.

2. Piezokeramischer Vielschichtaktor nach Anspruch 1, **dadurch gekennzeichnet, dass** die Tiefe (24) der Struktur (18) bis etwa 0,5 mm beträgt.

3. Piezokeramischer Vielschichtaktor nach einem der Ansprüche 1 oder 2, **dadurch gekennzeichnet, dass** die die Struktur (18) erzeugenden Abtragungen (19) der Oberfläche (10) des Aktors (1) aus Nuten (20) besteht.

4. Piezokeramischer Vielschichtaktor nach Anspruch 3 **dadurch gekennzeichnet, dass** die Nuten (20) parallel zueinander angeordnet sind.

5. Piezokeramischer Vielschichtaktor nach Anspruch 3 oder 4, **dadurch gekennzeichnet, dass** die Breite (22) einer Nut (20), der Abstand (21) zwischen zwei Nuten (20) und der Winkel (25) dieser Nuten (20) gegenüber der Längsachse (23) des Aktors (1) so aufeinander abgestimmt sind, dass nicht mehr als eine vorgegebene Anzahl von Innenelektroden (3) zwischen zwei Nuten an die Oberfläche (10) des Aktors tritt.

6. Piezokeramischer Vielschichtaktor nach einem der Ansprüche 3 bis 5, **dadurch gekennzeichnet, dass** die Breite (22) der Nuten (20) 0,2 mm bis 2 mm, vorzugsweise 0,2 mm bis 0,7 mm beträgt.

7. Piezokeramischer Vielschichtaktor nach einem der Ansprüche 3 bis 6, **dadurch gekennzeichnet, dass** die Nuten (20) in einem Abstand (21) von 0,2 mm bis 10 mm angeordnet sind.

8. Piezokeramischer Vielschichtaktor nach einem der Ansprüche 5 bis 7, **dadurch gekennzeichnet, dass** die optimale Anzahl von Innenelektroden (3), die zwischen zwei Nuten an die Oberfläche (10) des Aktors tritt, etwa fünf ist und damit der Abstand der Nuten (20) voneinander etwa 0,8 mm bis 1,2 mm beträgt.

9. Piezokeramischer Vielschichtaktor nach einem der Ansprüche 3 bis 8, **dadurch gekennzeichnet, dass** die Struktur (18) ein Gitter (26) aus sich kreuzenden Nuten (20) ist.

10. Piezokeramischer Vielschichtaktor nach einem der Ansprüche 1 bis 9 **dadurch gekennzeichnet, dass** der Aktor (1) die Struktur (18) in der Oberfläche (10) im Grünzustand aufweist.

11. Piezokeramischer Vielschichtaktor nach einem der Ansprüche 1 bis 9 **dadurch gekennzeichnet, dass** die Struktur (18) in der Oberfläche (10) des Aktors (1) im gesinterten Zustand erzeugbar ist.

12. Verfahren zur Herstellung eines piezokeramischen Vielschichtaktors mit alternierend an sich gegenüberliegenden Oberflächen des Aktors geführten innenelektroden, die auf der jeweiligen Oberfläche durch eine Außenelektrode miteinander verbunden sind, bei dem auf der Oberfläche des inaktiven Bereichs des Aktors durch Abtragungen der Oberfläche, die der Dicke des Isolierbereichs entspricht, eine Struktur erzeugt wird, **dadurch gekennzeichnet, dass** ausschließlich auf der durch die Struktur verbliebenen Oberfläche mindestens eine Schicht einer Grundmetallisierung und eine Verbindungsschicht aufgetragen wird, mit der eine Verstärkungsschicht verbunden wird, zur Bildung der Außenelektrode, dass an der Verstärkungsschicht ein Anschluss zu einer Spannungsquelle angelötet werden kann und dass durch das Abtragen der Oberfläche, das in einem Winkel von 0 Grad bis 80 Grad, vorzugsweise von 30 Grad bis 50 Grad, zur Längsachse des Aktors erfolgt, die Struktur erzeugt wird.

13. Verfahren nach Anspruch 11, **dadurch gekennzeichnet, dass** die Struktur durch Abtragen der Oberfläche des Aktors in einer Tiefe bis zu 0,5 mm erzeugt wird.

14. Verfahren nach einem der Ansprüche 12 oder 13, **dadurch gekennzeichnet, dass** durch Abtragen der Oberfläche des Aktors Nuten in einer Breite von 0,2 mm bis zu 2 mm erzeugt werden.

15. Verfahren nach Anspruch 14, **dadurch gekennzeichnet, dass** die Nuten parallel angeordnet werden.

16. Verfahren nach Anspruch 14 oder 15, **dadurch gekennzeichnet, dass** die Breite einer Nut, der Abstand zwischen zwei Nuten und der Winkel dieser Nuten gegenüber der Längsachse des Aktors so aufeinander abgestimmt werden, dass nicht mehr als eine vorgegebene Anzahl von Innenelektroden zwischen zwei Nuten an die Oberfläche des Aktors tritt.

17. Verfahren nach Anspruch 16, **dadurch gekennzeichnet, dass** die Anzahl von Innenelektroden, die zwischen zwei Nuten an die Oberfläche des Aktors tritt, mit fünf festgelegt wird.

18. Verfahren nach einem der Ansprüche 14 bis 17, **dadurch gekennzeichnet, dass** eine Gitterstruktur durch sich kreuzende Nuten erzeugt wird.

19. Verfahren nach einem der Ansprüche 12 bis 18, **dadurch gekennzeichnet, dass** die Struktur durch ein spangebendes Bearbeitungsverfahren erzeugt wird.

20. Verfahren nach einem der Ansprüche 12 bis 18, **dadurch gekennzeichnet, dass** die Struktur durch ein Laserverfahren erzeugt wird.

21. Verfahren nach einem der Ansprüche 12 bis 20, **dadurch gekennzeichnet, dass** die Struktur im Grünzustand des Aktors erzeugt wird.

22. Verfahren nach einem der Ansprüche 12 bis 20, **dadurch gekennzeichnet, dass** die Struktur im gesinterten Zustand des Aktors erzeugt wird.

## Claims

1. A piezoceramic multilayer actuator (1) with inner electrodes (3) brought out alternately at opposite surfaces (10) of the actuator (1), which inner electrodes are interconnected on the respective surface (10) by an outer electrode (4, 5), the surface (10) of the multilayer actuator (1) having a pattern (18) in the inactive region (14) that is produced by ablations (19) interrupting the surface (10), the depth (24) of which ablations corresponds to the thickness of the isolating region (14), **characterised in that** the outer electrode (4, 5) consists of at least one layer of a base metallisation (11) deposited on the inactive region (14) of the actuator (1), with which base metallisation a reinforcing layer (12) is connected by means of an interconnect layer (13), to which reinforcing layer a connection (6) to a voltage source can be soldered, that the base metallisation (11) is deposited exclusively on the surface (10) left by the pattern (18), and that the ablations (19) producing the pattern (18) run at an angle of 0 degrees to 80 degrees, preferably of 30 degrees to 50 degrees, to the longitudinal axis (23) of the actuator (1).

2. A piezoceramic multilayer actuator according to claim 1, **characterised in that** the depth (24) of the pattern (18) is up to approximately 0.5 mm.

3. A piezoceramic multilayer actuator according to one of claims 1 or 2, **characterised in that** the ablations (19) of the surface (10) of the actuator (1), producing the pattern (18) consist of grooves (20).

4. A piezoceramic multilayer actuator according to claim 3, **characterised in that** the grooves (20) are disposed parallel to one another.

5. A piezoceramic multilayer actuator according to claim 3 or 4, **characterised in that** the width (22) of a groove (20), the spacing (21) between two grooves (20) and the angle (25) of these grooves (20) with respect to the longitudinal axis (23) of the actuator (1) are adjusted with respect to one another so that no more than a predetermined number of inner electrodes (3) occurs between two grooves at the surface (10) of the actuator.

6. A piezoceramic multilayer actuator according to one of claims 3 to 5, **characterised in that** the width (22) of the grooves (20) is 0.2 mm to 2 mm, preferably 0.2 mm to 0.7 mm.

7. A piezoceramic multilayer actuator according to one of claims 3 to 6, **characterised in that** the grooves (20) are disposed at a spacing (21) of 0.2 mm to 10 mm.

8. A piezoceramic multilayer actuator according to one of claims 5 to 7, **characterised in that** the optimum number of inner electrodes (3) that occurs between two grooves at the surface (10) of the actuator is approximately five and thus the spacing of the grooves (20) between one another is approximately 0.8 mm to 1.2 mm.

9. A piezoceramic multilayer actuator according to one of claims 3 to 8, **characterised in** the pattern (18) is a grating (26) of crossing grooves (20).

10. A piezoceramic multilayer actuator according to one of claims 1 to 9, **characterised in that** the actuator (1) has the pattern (18) in the surface (10) in the green state.

11. A piezoceramic multilayer actuator according to one of claims 1 to 9, **characterised in that** the pattern (18) can be produced in the surface (10) of the actuator (1) in the sintered state.

12. A process for the manufacture of a piezoceramic multilayer actuator with inner electrodes brought out alternately at opposite surfaces of the actuator, which inner electrodes are interconnected on the respective surface by an outer electrode, in which process a pattern is produced on the surface of the inactive region of the actuator by ablations in the surface corresponding to the thickness of the isolating region, **characterised in that** for forming the outer electrode at least one layer of a base metallisation and an interconnect layer, with which a reinforcing layer is connected, is deposited exclusively on the surface left by the pattern, that a connection to a voltage source can be soldered to the reinforcing layer, and that the pattern is produced by ablating the surface at an angle of 0 degrees to 80 degrees, preferably of 30 degrees to 50 degrees, to the longitudinal axis of the actuator.

13. A process according to claim 11, **characterised in that** the pattern is produced by ablating the surface of the actuator to a depth of up to 0.5 mm.

14. A process according to one of claims 12 or 13, **characterised in that**, by ablating the surface of the actuator, grooves to a depth of from 0.2 mm up to 2 mm are produced.

15. A process according to claim 14, **characterised in that** the grooves are disposed in parallel.

16. A process according to claim 14 or 15, **characterised in that** the width of a groove, the spacing between two grooves and the angle of these grooves with respect to the longitudinal axis of the actuator are adjusted with respect to one another so that no more than a predetermined number of inner electrodes occurs between two grooves at the surface of the actuator.

17. A process according to claim 16, **characterised in that** the number of inner electrodes that occurs between two grooves in the surface of the actuator is set at five.

18. A process according to one of claims 14 to 17, **characterised in that** the grating pattern is produced by crossing grooves.

19. A process according to one of claims 12 to 18, **characterised in that** the pattern is produced by a machine cutting process.

20. A process according to one of claims 12 to 18, **characterised in that** the pattern is produced by a laser process.

21. A process according to one of claims 12 to 20, **characterised in that** the pattern is produced in the green state of the actuator.

22. A process according to one of claims 12 to 20, **characterised in that** the pattern is produced in the sintered state of the actuator.

## Revendications

1. Actionneur multicouche piézocéramique (1), comportant des électrodes internes qui s'étendent en alternance à partir de surfaces opposées (10) de l'actionneur (1) et qui sont reliées les unes aux autres par une électrode externe (4, 5) attachée à la surface (10) respective, laquelle surface (10) de l'actionneur multicouche (1) présente, dans le domaine inactif (14), une structure (18) formée par des évidements (19) qui rompent la continuité de la surface (10) et dont la profondeur (24) correspond à l'épaisseur du domaine isolant (14), **caractérisé en ce que** l'électrode externe (4, 5) consiste en au moins une couche d'un matériau de métallisation de base (11), déposée sur le domaine inactif (14) de l'actionneur (1), à laquelle couche est attachée, par l'intermédiaire d'une couche de liaison (13), une couche de renfort (12) à laquelle peut être soudée une connexion (6) vers une source de tension, **en ce que** le matériau de métallisation de base (11) est exclusivement déposé sur la surface (10) que laisse la structure (18), et **en ce que** les évidements (19) formant la structure (18) sont dirigés selon un angle de 0° à 80°, et de préférence de 30° à 50°, par rapport à l'axe longitudinal (23) de l'actionneur (1).

2. Actionneur multicouche piézocéramique, conforme à la revendication 1, **caractérisé en ce que** la profondeur (24) de la stucture (18) vaut jusqu'à peu près 0,5 mm.

3. Actionneur multicouche piézocéramique, conforme à la revendication 1 ou 2, **caractérisé en ce que** les évidements (19) formant la structure (18) à la surface (10) de l'actionneur (1) sont des entailles (20).

4. Actionneur multicouche piézocéramique, conforme à la revendication 3, **caractérisé en ce que** les entailles (20) sont dirigées parallèlement les unes aux autres.

5. Actionneur multicouche piézocéramique, conforme à la revendication 3 ou 4, **caractérisé en ce que** la largeur (22) d'une entaille (20), la distance (21) entre deux entailles (20) et l'angle (25) que font ces entailles (20) avec l'axe longitudinal (23) de l'actionneur (1) sont définis l'un par rapport à l'autre de telle sorte qu'il n'y a pas plus d'un nombre prédéterminé d'électrodes internes (3) qui apparaissent entre deux entailles à la surface (10) de l'actionneur.

6. Actionneur multicouche piézocéramique, conforme à l'une des revendications 3 à 5, **caractérisé en ce que** la largeur (22) des entailles (20) vaut de 0,2 à 2 mm, et de préférence de 0,2 à 0,7 mm.

7. Actionneur multicouche piézocéramique, conforme à l'une des revendications 3 à 6, **caractérisé en ce que** les entailles (20) sont disposées à une distance (21) de 0,2 à 10 mm.

8. Actionneur multicouche piézocéramique, conforme à l'une des revendications 5 à 7, **caractérisé en ce que** le nombre optimal d'électrodes internes (3) qui apparaissent entre deux entailles à la surface (10) de l'actionneur vaut à peu près cinq, et que pour cela, la distance d'une entaille (20) à l'autre vaut à peu près 0,8 à 1,2 mm.

9. Actionneur multicouche piézocéramique, conforme à l'une des revendications 3 à 8, **caractérisé en ce que** la structure (18) est un réseau (26) formé d'entailles (20) entrecroisées.

10. Actionneur multicouche piézocéramique, conforme à l'une des revendications 1 à 9, **caractérisé en ce que** l'actionneur (1) présente, à l'état cru, la structure (18) dans sa surface (10).

11. Actionneur multicouche piézocéramique, conforme à l'une des revendications 1 à 9, **caractérisé en ce que** la structure (18) peut être produite dans la surface (10) de l'actionneur (1) à l'état fritté.

12. Procédé de fabrication d'un actionneur multicouche piézocéramique comportant des électrodes internes qui s'étendent en alternance à partir de surfaces opposées de l'actionneur et qui sont reliées les unes aux autres par une électrode externe attachée à la surface respective, dans lequel procédé l'on produit une structure sur la surface du domaine inactif de l'actionneur, en pratiquant sur cette surface des évidements dont la profondeur correspond à l'épaisseur du domaine isolant, **caractérisé en ce qu'**on dépose, exclusivement sur la surface que laisse la structure, au moins une couche d'un matériau de métallisation de base et une couche de liaison à laquelle est attachée une couche de renfort, pour former une électrode externe, **en ce qu'**une connexion vers une source de tension peut être soudée à la couche de renfort, et **en ce que** l'on forme la structure par creusement de la surface, selon un angle de 0° à 80°, et de préférence de 30° à 50°, par rapport à l'axe longitudinal de l'actionneur.

13. Procédé conforme à la revendication 12, **caractérisé en ce que** l'on produit la structure en creusant la surface de l'actionneur sur une profondeur allant jusquà 0,5 mm.

14. Procédé conforme à la revendication 12 ou 13, **caractérisé en ce que** l'on forme, en creusant la surface de l'actionneur, des entailles larges de 0,2 à 2 mm.

15. Procédé conforme à la revendication 14, **caractérisé en ce que** les entailles sont dirigées parallèlement les unes aux autres.

16. Procédé conforme à la revendication 14 ou 15, **caractérisé en ce que** la largeur d'une entaille, la distance entre deux entailles et l'angle que font ces entailles avec l'axe longitudinal de l'actionneur sont définis l'un par rapport à l'autre de telle sorte qu'il n'y a pas plus d'un nombre prédéterminé d'électrodes internes qui apparaissent entre deux entailles à la surface de l'actionneur.

17. Procédé conforme à la revendication 16, **caractérisé en ce que** l'on fixe à cinq le nombre d'électrodes internes qui apparaissent entre deux entailles à la surface de l'actionneur.

18. Procédé conforme à l'une des revendications 14 à 17, **caractérisé en ce que** l'on produit une structure en réseau, au moyen d'entailles entrecroisées.

19. Procédé conforme à l'une des revendications 12 à 18, **caractérisé en ce que** l'on produit la structure par un procédé d'usinage générateur de contraintes.

20. Procédé conforme à l'une des revendications 12 à 18, **caractérisé en ce que** l'on produit la structure par un procédé laser.

21. Procédé conforme à l'une des revendications 12 à 20, **caractérisé en ce que** l'on produit la structure alors que l'actionneur est à l'état cru.

22. Procédé conforme à l'une des revendications 12 à 20, **caractérisé en ce que** l'on produit la structure alors que l'actionneur est à l'état fritté.
